# EUROPEAN PATENT SPECIFICATION

(11) **EP 4 078 404 B1**
(45) Date of publication and mention of the grant of the patent: **20.11.2024**
(21) Application number: 20902057.7
(22) Date of filing: 15.12.2020
(51) Int. Cl.: G06F 16/2455, G06F 16/174, G06F 16/20, H03M 7/30, G16Y 20/00, G06F 16/2458

(54) **METHOD AND APPARATUS FOR STORING AND QUERYING TIME SERIES DATA, AND SERVER AND STORAGE MEDIUM THEREOF**
VERFAHREN UND VORRICHTUNG ZUM SPEICHERN UND ABFRAGEN VON ZEITREIHENDATEN SOWIE SERVER UND SPEICHERMEDIUM DAFÜR
PROCÉDÉ ET APPAREIL DE MÉMORISATION ET D'INTERROGATION DE DONNÉES DE SÉRIE CHRONOLOGIQUE ET SERVEUR ET SUPPORT DE STOCKAGE ASSOCIÉS

(30) Priority: 19.12.2019 CN 201911318297
(43) Date of publication of application: 26.10.2022
(73) Proprietor: Envision Digital International Pte. Ltd., Singapore 098632 (SG); Shanghai Envision Digital Co., Ltd., China (Shanghai) Pilot Free Trade Zone Shanghai (CN)
(72) Inventor: HUANG, Yueqin, Shanghai (CN); SHAN, Yihui, Shanghai (CN); ZHAO, Hong, Shanghai (CN)
(74) Representative: Dennemeyer & Associates S.A.
(86) International application number: PCT/SG2020/050748
(87) International publication number: WO 2021/126079

(56) References cited:
- WO-A2-2018/049430
- CN-A- 106 021 395
- CN-A- 108 021 650
- CN-A- 108 256 088
- CN-A- 109 582 708
- US-A1- 2018 284 741
- US-A1- 2018 373 756
- ANONYMOUS: "Huffman coding", WIKIPEDIA, THE FREE ENCYCLOPEDIA, 18 January 2013 (2013-01-18), pages 1 - 10, XP055303125, Retrieved from the Internet <URL:https://en.wikipedia.org/w/index.php?title=Huffman_coding&oldid=533661878> [retrieved on 20160915]

## Description

### TECHNICAL FIELD

The embodiments of the present disclosure relate to the field of databases, and in particular to a method and apparatus for storing and querying time series data, and a server and a storage medium thereof.

### BACKGROUND

Time series data refers to data sequences recorded by the same indicator in chronological order, while a time series database is a specialized database used to store and manage time series data. A time series database in an Internet of things (IoT) system is usually used to store data generated in a large number of scenarios of real-time monitoring, alarming, and analysis and needs to provide larger storage space and the ability to quickly query and process data.

In related arts, upon acquiring data to be stored, a database server stores the data to be stored in a relevant file based on a timestamp, and compresses the file. When data is queried, the relevant file is decompressed in response to a query instruction and the data to be queried is returned.

However, the time series database in related technologies stores all data indiscriminately, and cannot provide targeted compression and storage methods for different types of data, and the compression rate is low.
US 2018/284741 A1 discloses a system, method and apparatus for data collection in an industrial production environment. The system may include, a data acquisition circuit structured to interpret a plurality of detection values, each of the plurality of detection values corresponding to input received from at least one of a plurality of input sensors which includes a detection package, each of the plurality of input sensors operatively coupled to at least one of a plurality of components of an industrial production process, a data analysis circuit structured to analyze a subset of the plurality of detection values to determine a sensor performance value of at least one of the plurality of input sensors, and an analysis response circuit structured to adjust at least one of a sensor scaling value or a sensor sampling frequency value, in response to the sensor performance value.
Further prior art is known from the Wikipedia article for "Huffman coding".

### SUMMARY

The underlying problem of the present invention is solved by the subject matter of the independent claims. According to embodiments of the present disclosure, a method and apparatus for storing and querying time series data, and a server and a storage medium thereof are provided.

In one aspect, embodiments of the present disclosure provide a method for storing and querying time series data. The method includes:
upon receiving data to be stored from an IoT device, determining a data type of the data to be stored, wherein the data to be stored is time series data, and the data type is intended to indicate a change in the time series data over time;
obtaining compressed data by compressing the data to be stored by a data compression method corresponding to the data type wherein different data types correspond to different data compression methods;
storing the compressed data to a data storage table corresponding to the data type, wherein different data types correspond to different data storage tables;
receiving a query request, wherein the query request includes a query data type and a query time condition; and
querying target data that meets the query time condition from a data storage table corresponding to the query data type.

In another aspect, embodiments of the present disclosure provide an apparatus for storing and querying time series data. The apparatus includes:
a determining module, configured to, upon receiving data to be stored from an IoT device, determine a data type of the data to be stored, wherein the data to be stored is time series data, and the data type is intended to indicate a change in the time series data over time;
a processing module, configured to obtain compressed data by compressing the data to be stored by a data compression method corresponding to the data type, wherein different data types correspond to different data compression methods;
a storing module, configured to store the compressed data to a data storage table corresponding to the data type, wherein different data types correspond to different data storage tables;
a receiving module, configured to receive a query request, wherein the query request includes a query data type and a query time condition; and
a querying module, configured to query target data that meets the query time condition from a data storage table corresponding to the query data type.

In another aspect, embodiments of the present disclosure provide a server. The server includes a processor and a memory. The memory stores at least one instruction, at least one program, a code set, or an instruction set. The at least one instruction, the at least one program, the code set, or the instruction set, when loaded and executed by the processor, causes the processor to perform the method for storing and querying time series data as described in the above aspect.

In another aspect, embodiments of the present disclosure provide a computer-readable storage medium. The computer-readable storage medium stores at least one instruction, at least one program, a code set, or an instruction set. The at least one instruction, the at least one program, the code set, or the instruction set, when loaded and executed by a processor, causes the processor to perform the method for storing and querying time series data as described in the above aspect.

The technical solutions according to the embodiments of the present disclosure achieve at least the following beneficial effects.

A data type of data to be stored is determined. Different types of data are compressed and stored to corresponding data storage tables by different compression methods based on the characteristics thereof, thereby improving the compression efficiency of time series data and saving storage resources. Moreover, during data query, time series data that meets a query time condition is searched from a data storage table corresponding to a query data type, which improves the query efficiency of different types of time series data.

### BRIEF DESCRIPTION OF THE DRAWINGS

FIG. 1 is a schematic diagram showing an implementation environment according to an exemplary embodiment;
FIG. 2 is a flowchart of a method for storing and querying time series data according to an exemplary embodiment;
FIG. 3 is a schematic diagram of a compression and storage process of time series data according to an exemplary embodiment;
FIG. 4 is a flowchart of a method for storing and querying time series data according to another exemplary embodiment;
FIG. 5 is a schematic diagram showing query capabilities of a database server according to an exemplary embodiment;
FIG. 6 is a structural block diagram of an apparatus for storing and querying time series data according to an exemplary embodiment; and
FIG. 7 is a schematic diagram showing the structure of a server according to an exemplary embodiment.

### DETAILED DESCRIPTION

In order to make the objects, technical solutions, and advantages of the present disclosure clearer, the following will further describe the embodiments of the present disclosure in detail with reference to the accompanying drawings.

The term "a plurality of" mentioned herein means two or more, and the term "and/or" describes an association relationship of associated objects, indicating that there may be three types of relationships. For example, A and/or B may indicate three situations: A exists alone, A and B exist simultaneously, and B exists alone. The character "/" generally indicates that the associated objects are in an "or" relationship.

In related arts, time series database software is usually used for the storage of time series data. For data to be stored with different indicators sent by different IoT devices, a database server stores it in a corresponding data storage table, but all data is compressed by a default compression method of the time series database software defaults, which results in low compression rate. Moreover, the query computing power of the database is limited, which requires a lot of other service logic support.

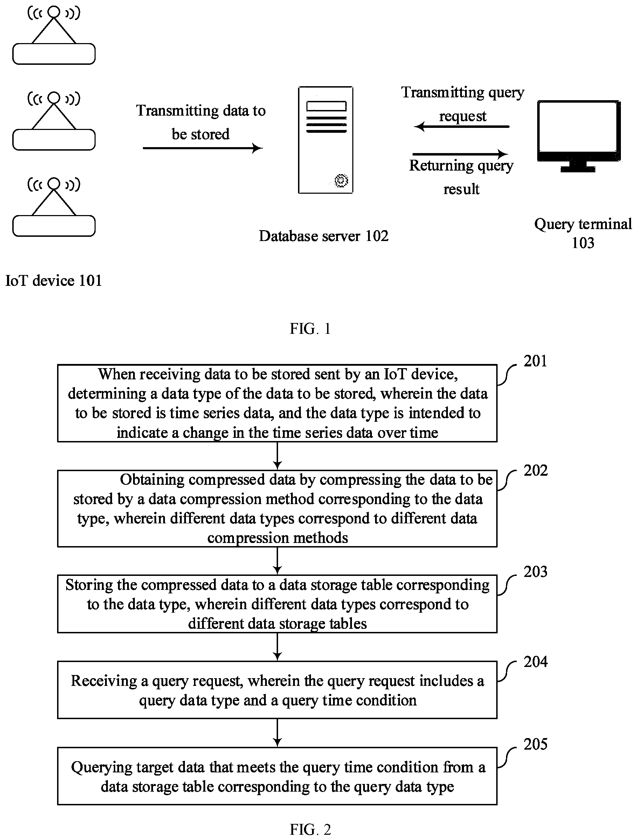

In order to solve the foregoing problems, the embodiments of the present disclosure provide a method for storing and querying time series data for time series data of different data types. FIG. 1 shows a schematic diagram of an implementation environment according to an exemplary embodiment of the present disclosure. The implementation environment includes an Internet of things (IoT) device 101, a database server 102, and a query terminal 103.

The IoT device 101 is a device with a data acquisition function for acquiring time series data, which may be a new energy device equipped with sensors such as a wind speed detector, a temperature and humidity detector, and a photovoltaic sensor, such as a wind generator and a photovoltaic panel. As shown in FIG. 1, a plurality of IoT devices 101 acquire time series data of different data types, and send the acquired time series data to the database server 102. In a possible application scenario, the IoT device 101 sends the data to the database server 102 by a gateway device.

The IoT device 101 and the database server 102 are connected over a wired or wireless network.

The database server 102 is a storage device that stores the data acquired by the IoT device 101, which may be a server, a server cluster composed of several servers, or a cloud server. Optionally, the database server 102 acquires data to be stored sent by the IoT device 101, determines a corresponding data compression method based on a data type of the data to be stored, and stores compressed data in a corresponding data storage table.

The database server 102 and the query terminal 103 are connected over a wired or wireless network.

The query terminal 103 is a device with a data query function. In a possible application scenario, the query terminal 103 sends a query request containing a query data type and a query time condition to the database server 102. The database server 102 determines a corresponding data storage table based on the query data type, decompresses the data storage table, determines target data in the data storage table based on the query time condition, and feeds back a query result to the query terminal 103. The query terminal 103 displays the received time series data in the form of a chart. The query terminal 103 may be a personal computer, a smart phone, a tablet computer, or the like. As shown in FIG. 1, the query terminal 103 is a personal computer.

FIG. 2 shows a flowchart of a method for storing and querying time series data according to an exemplary embodiment of the present disclosure. In this embodiment, the method being applied to a database server is taken as an example for description. The method includes the following steps.

In step 201, after data to be stored is received from an IoT device, a data type of the data to be stored is determined. The data to be stored is time series data. The data type is intended to indicate a change in the time series data over time.

Time series data refers to data sequences recorded by the same indicator in chronological order. In an IoT system, time series data acquired by different IoT devices vary over time. Therefore, in some embodiments, data acquired by an IoT device may be categorized into different types of data based on changes thereof over time in advance. When receiving data to be stored from the IoT device, the database server may first determine its data type.

Optionally, upon receiving data to be stored sent by an IoT device, the database server may determine its data type based on a device identifier or a keyword indicating a data indicator carried in the data to be stored.

In step 202, compressed data is obtained by compressing the data to be stored by a data compression method corresponding to the data type. Different data types correspond to different data compression methods.

The database server categorizes the data into different types, and compresses each type of data in a corresponding manner, thereby maximizing a compression rate of the database.

In some embodiments, the database server is preset with multiple data compression methods, and matches a corresponding compression method for each type of data. After a data type of the data to be stored is determined, the data is compressed by a corresponding data compression method.

In step 203, the compressed data is stored to a data storage table corresponding to the data type. Different data types correspond to different data storage tables.

Compared with relational databases, time series databases (such as Open TSDB) in related technologies have characteristics of high throughput and high compression rate. However, the data storage table is sole and cannot perform classified storage based on data types of time series data. Therefore, the data processing capacity of the time series database is limited.

In some embodiments, the database server is provided with a plurality of types of data storage tables. Data of different data types is allocated to different data storage tables for isolated storage. On this basis, different data query capabilities are provided to improve the data query efficiency of the database. The database server compresses the data to be stored by a corresponding data compression method based on the data type thereof, and then stores compressed data in a corresponding data storage table.

Optionally, the database server marks different types of data storage tables which correspond to marks indicating data types in the data to be stored, compresses the data to be stored, and then stores the same in a corresponding data storage table. Since the data acquired by the IoT device is time series data, the database server stores the data to be stored to a data storage table in the order of time stamp.

In step 204, a query request is received. The query request includes a query data type and a query time condition.

In addition to storing the data sent by the IoT device, the database server also has a query function. Users may send query requests as needed, and perform data analysis based on query results returned by the database server to obtain a change trend of a certain indicator, an increase or decrease in revenue or data details within a specific time and other information.

In some embodiments, a user inputs a query request on a client. The database server receives the query request and obtains a query data type and a query time condition in the query request. The query data type is intended to determine a data storage table. The query time condition is intended to determine data in the data storage table.

In step 205, target data that meets the query time condition is queried from a data storage table corresponding to the query data type.

In some embodiments, the database server acquires the query data type in the query request, determines a data storage table corresponding to the type, decompresses the data storage table, determines and extracts target data in the data storage table based on the query time condition, and returns a query result.

If the query request also contains other query conditions, the database server performs statistical analysis and calculation processing on the target data based on a specific query condition.

In summary, in the embodiments of the present disclosure, a data type of data to be stored is determined, and different types of data are compressed and stored in corresponding data storage tables by different compression methods based on the characteristics thereof, which can greatly improve compression efficiency and save system resources. On the basis of different types of data storage tables, target data is determined based on a query condition, which provides rich query capabilities, and improves data query efficiency.

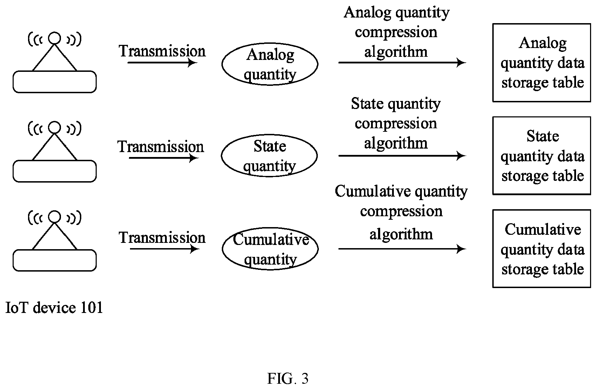

In an IoT system, time series data acquired by an IoT device mainly includes three types, namely an analog quantity, a state quantity, and a cumulative quantity. Changes in different types of time series data change over time are different. The state quantity is a physical quantity that is discontinuous over time and has a value belonging to a preset enumerated data set, such as a position signal of a circuit breaker or an isolating switch, an action signal of a protection device, or an operation state signal of a communication device. The analog quantity is a physical quantity that is continuous over time and has a value within a preset value range but cannot be enumerated, such as temperature, wind speed, or voltage value. The cumulative quantity is a physical quantity whose value increases progressively over time and is a cumulative value of a certain indicator over a time period, such as electric meter reading, or car mileage. FIG. 3 shows a schematic diagram of a data storage process according to an exemplary embodiment of the present disclosure. The data sent by the IoT device 101 to the database server is categorized into an analog quantity, a state quantity, a cumulative quantity, and other types of data. The database server compresses the data to be stored by a corresponding compression algorithm based on the data type of the data to be stored, and stores compressed data in a corresponding data storage table. The present disclosure illustrates the method for storing and querying time series data by taking an analog quantity, a state quantity, and a cumulative quantity as examples.

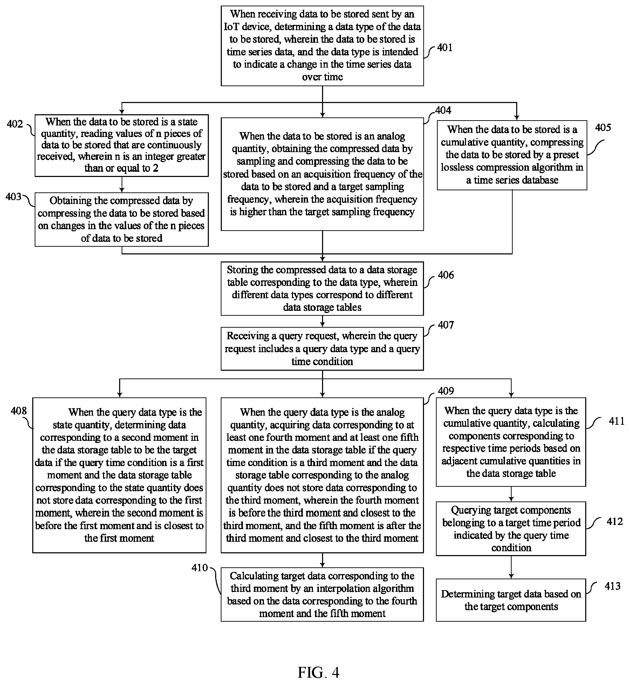

FIG. 4 shows a flowchart of a method for storing and querying time series data according to another exemplary embodiment of the present disclosure. In this embodiment, the method being applied to a database server is taken as an example for description. The method includes the following steps.

In step 401, after data to be stored is received from an IoT device, a data type of the data to be stored is determined. The data to be stored is time series data. The data type is intended to indicate a change in the time series data over time.

For details of this step, reference may be made to step 201, which are not repeated in this embodiment.

In step 402, when the data to be stored is a state quantity, values of n pieces of data to be stored that are continuously received are read, wherein n is an integer greater than or equal to 2.

Regarding the state quantity, only the time point and data of change are concerned during query and calculation, and data within the time period when no change occurs is not concerned. Therefore, it is unnecessary to store every piece of data sent by the IoT device, and only data at the moment when the state quantity changes is stored.

In some embodiments, in order to only retain data when a change occurs, the database server needs to compare the values of the data to be stored. When n pieces of data to be stored are continuously received, the database server first reads values of the n pieces of data to be stored, wherein n may be set according to the actual data acquisition situation of the IoT device.

In some embodiments, a switch of the IoT device has two positions: on and off. It uploads data containing a switch position signal to the database server every one minute. An on state is represented by a number 0. An off state is represented by a number 1. Before 10:02:00, the switch position signal of the loT device is 0. The switch position signal becomes 1 at 10:02:00 and continues until 10:05:00. At 10:06:00, the value of the state quantity uploaded by the IoT device is 0. That is, between 10:00:00 and 10:06:00, the switch position signal data of the IoT device is 0, 0, 1, 1, 1, 1, 0. If the database server is set to acquires values of 5 pieces of data to be stored at one time and the previous acquisition is until 10:01:00, the database server acquires values of the data to be stored from 10:02:00 to 10:06:00 at this time, namely 1, 1, 1, 1, 0.

In step 403, compressed data is obtained by compressing the data to be stored based on changes in the values of the n pieces of data to be stored.

Regarding the state quantity, a user usually only cares about data at the moment of change when querying, so the data server performs compression and storage based on a change in the value of the data to be stored.

In some embodiments, this step may include the following sub-steps:
1. For an (i+1)^{th} piece of data to be stored among the n pieces of data to be stored, if a value of the (i+1)^{th} piece of data to be stored is different from that of an i^{th} piece of data to be stored, then the (i+1)^{th} piece of data to be stored is retained, where i is an integer greater than or equal to 1.

In some embodiments, when the data to be stored is a state quantity, the database server reads the values of the n pieces of data to be stored, and then compares values of data other than a first piece of data among the n pieces of data to be stored with a value of a previous piece of data. If a value of a certain piece of data is different from that of a previous piece of data, the data is retained. The first piece of data among the n pieces of data to be stored needs to be compared with a value of the last state quantity stored in the corresponding data storage table. If they are different, the first piece of data is retained.

In some embodiments, the switch position signal data of the IoT device acquired by the database server from 10:02:00 to 10:06:00 is 1, 1, 1, 1, 0. Starting from a second piece of data to be stored, a value of each piece of data to be stored is compared with that of a previous piece of data to be stored. If the values are different, the piece of data to be stored is retained. That is, the data at 10:06:00 is retained. A value of the first piece of data to be stored needs to be compared with that of the last piece of data in the corresponding data storage table with a purpose to determine whether the first piece of data to be stored is a piece of data that has changed. If the value of the last piece of data in the data storage table is 0, then the data at 10:02:00 is retained.

2. If the value of the (i+1)^{th} piece of data to be stored is the same as that of the i^{th} piece of data to be stored, the (i+1)^{th} piece of data to be stored is deleted.

Starting from a second piece of data among the n pieces of data, if a value of a current piece of data to be stored is the same as that of a previous piece of data to be stored, the current piece of data is deleted. A value of a first piece of data to be stored needs to be compared with that of the last piece of data in the corresponding data storage table. If they are the same, the first piece of data to be stored is deleted.

In some embodiments, the switch position signal data of the IoT device acquired by the database server from 10:02:00 to 10:06:00 is 1, 1, 1, 1, 0. Starting from a second piece of data to be stored, a value of each piece of data to be stored is compared with that of a previous piece of data to be stored. If the values are the same, a current piece of data to be stored is deleted. That is, three pieces of data from 10:03:00 to 10:05:00 need to be deleted. The data at 10:02:00 needs to be compared with a value of the last piece of data in the corresponding data storage table. If the values are the same, the first piece of data to be stored is deleted. If they are different, the first piece of data to be stored is retained. Because the value of the data to be stored at 10:02:00 is difference from that of the last piece of data in the data storage table, it indicates that the switch state changes at 10:02:00, and the data is retained.

In step 404, when the data to be stored is an analog quantity, the compressed data is obtained by compressively sampling the data to be stored based on an acquisition frequency of the data to be stored and a target sampling frequency. The acquisition frequency is higher than the target sampling frequency.

In some embodiments, data acquired by an IoT device is an analog quantity, and an acquisition frequency is relatively high. However, if a user needs a change trend of the analog quantity within a long time period when querying and analyzing or statistical results of the data and do not need specific details, the database server may compress the data to be stored of the analog quantity by sampling and compression. That is, the database server retains one piece of data to be stored at predetermined time intervals based on a preset target sampling frequency and delete the remaining data, thereby reducing the space occupied by the data. The target sampling frequency is smaller than the acquisition frequency of the IoT device.

In some embodiments, the IoT device is a wind speed detector, which acquires the wind speed every 10 seconds and uploads it to the database server. Since the wind speed generally does not change abruptly and a user usually only needs to query the wind speed changes in a few hours or a day, a specific wind speed every 10 seconds does not need to be specified. A target sampling frequency of the database server for the analog data sent by the IoT device may be set to once every minute. For example, from 10:00:00 to 10:01:00, the IoT device acquires 7 sets of wind speeds and uploads them to the database server. The database server only retains data at 10:00:00 and 10:01:00 based on the target sampling frequency once per minute and compresses the data, and delete the remaining 5 groups of data.

Optionally, the data to be stored whose data type is an analog quantity may be compressed by a lossless compression method of a time series database, such as Huffman compression algorithm.

In step 405, when the data to be stored is a cumulative quantity, the data to be stored is compressed by a preset lossless compression algorithm of a time series database.

Since a value of the cumulative quantity increases progressively over time which is a cumulative value of a certain indicator and usually its data acquisition frequency is relatively low, it is necessary to retain complete data when performing compression and storage. In some embodiments, the database server compresses the cumulative quantity by a lossless compression method of a time series database.

It should be noted that no strict order is defined between steps 402 to 403 and step 404 and step 405. That is, steps 402 to 403 and step 404 and step 405 may be performed synchronously, which is not limited in this embodiment.

In step 406, the compressed data is stored to a data storage table corresponding to the data type. Different data types correspond to different data storage tables.

In some embodiments, the database server is provided with a plurality of types of data storage tables. Each type of data storage table corresponds to one data type, and only stores data of that type. When a user needs to query data, he/she only needs to decompress the corresponding data storage table. Based on different types of data storage tables, corresponding query algorithms are set to enable the database server to have rich query capabilities.

In step 407, a query request is received. The query request includes a query data type and a query time condition.

In addition to storing the data acquired by the IoT device, the database server also has data query and analysis capabilities, and provides different query capabilities for different types of data.

In some embodiments, a user initiates a query request on a client, which includes a query data type and a query time conditions. After the database server receives the query request from the client, it determines and decompresses a corresponding data storage table based on the query data type, and then determines relevant data in the data storage table based on the query time condition.

In some embodiments, a query data type, a query object, a query time condition, and a query service need to be entered in a query interface. For example, a user may enter the minimum temperature of each day in November 2019 in a certain area in the query analog quantity.

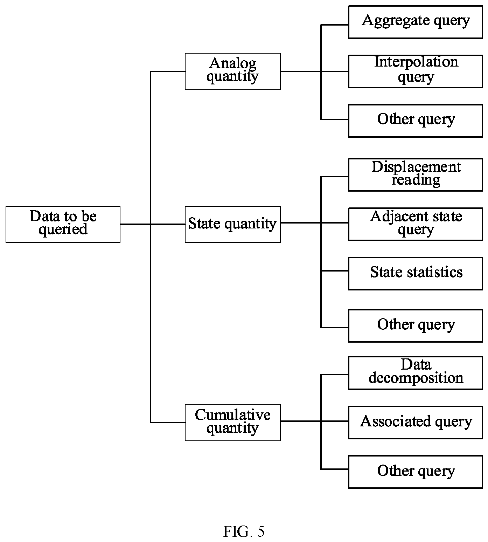

As shown in FIG. 5, different types of data have different query requirements. Since the database server stores each type of data separately in a corresponding data storage table, it can meet the query requirements of each type of data. For example, a user may perform basic aggregation queries (such as summation, average, and solving minimum and maximum values) and interpolation queries for analog data, and may also set other query methods according to the actual data. For a state quantity, displacement reading, adjacent state query, state statistics, and the like may be performed. For a cumulative quantity, it is usually necessary to perform data decomposition and perform related queries on this basis, for example, querying related fees such as related costs and benefits.

In step 408, when the query data type is the state quantity, if the query time condition is a first moment and a data storage table corresponding to the state quantity does not store data corresponding to the first moment, then data corresponding to a second moment in the data storage table is determined to be target data. The second moment is before the first moment and is closest to the first moment.

In some embodiments, because the compression method of the state quantity is to only retain data when a change occurs and delete data when no change occurs, the data is not complete, and there may be no corresponding data stored in the data storage table at the first moment of user input. However, since the stored data is unchanged data, its value is equal to that of data in the data storage table that is closest to its moment and before that moment. That is, the data corresponding to the second moment is the target data, and the database server returns the data at the second moment.

In some embodiment, if a user needs to query the switch state of the IoT device at 10:04:00, after a corresponding data storage table is determined based on the data type and it is detected that no data is present at that moment, data closest to that moment and before that moment is returned, i.e., data at 10:02:00 with a value of 1, which indicates that the switch state of the IoT device is off at 10:04:00.

In some embodiments, the query data type is the state quantity. If the query time condition is a target time period, data within the target time period in the data storage table is determined as target data. When a user needs to query a state quantity or a statistical result of the state quantity within a time period, the query time condition is one time period, and the database server returns the state quantity or the statistical result thereof within this time period.

In some embodiments, if a user needs to query statistical results of state quantities of the IoT device from 10:01:00 to 10:06:00, the database server determines a corresponding data storage table and determines target data based on the time period of the query time condition to acquire data at 10:02:00 and 10:06:00, the values of which are 1 and 0 respectively. The returned statistical results are once on and once off.

In step 409, when the query data type is the analog quantity, if the query time condition is a third moment and a data storage table corresponding to the analog quantity does not store data corresponding to the third moment, data corresponding to at least one fourth moment and at least one fifth moment in the data storage table is acquired. The fourth moment is before the third moment and closest to the third moment. The fifth moment is after the third moment and closest to the third moment.

In some embodiments, since the compression method of the analog quantity may be sampling and compression, the data thereof is incomplete, and data at a certain moment queried by a user may not be stored in the data storage table. The database server first determines data at two moments or within two time periods that are closest to the third moment of the query time condition before and after.

In some embodiments, if a user needs to query the wind speed acquired by the IoT device at 10:00:30, since the IoT device acquires data every one minute for compression and storage, no data at 10:00:30 is not present in the data storage table. At this moment, the database server acquires data at 10:00:00 and several moments before and data at 10:01:00 and several moments after.

In step 410, target data corresponding to the third moment is calculated by an interpolation algorithm based on the data corresponding to the fourth moment and the fifth moment.

According to data corresponding to a moment adjacent to the third moment, the database server fits a function of data within a time period including the third moment by an interpolation algorithm, calculates data corresponding to the third moment, and returns a calculation result.

In some embodiments, if a user needs to query the wind speed acquired by the IoT device at 10:00:30, the database server calculates the wind speed at 10:00:30 based on data at 10:00:00, 09:59:00 and 09:58:00 and data at 10:01:00, 10:02:00 and 10:03:00. Assuming that the wind speeds corresponding to 10:00:00, 09:59:00, 09:58:00, 10:01:00, 10:02:00 and 10:03:00 are all 5m/s, a function is fitted and the wind speed at 10:00:30 is calculated to be 5m/s.

In some embodiments, the query data type is the analog quantity. If the query time condition is a target time period, target data corresponding to the target time period in the data storage table is acquired. If the query request also includes other query conditions, a target function is determined based on a specific query condition, the target data is calculated and processed based on the target function, and a calculation result is obtained and returned to a query device.

In some embodiments, if a user needs to query the maximum wind speed from 00:00:00 to 12:00:00 acquired by the IoT device, the database server determines data within this time period in a corresponding data storage table, determines a function to solve the maximum value, calculates the maximum value of wind speed from 00:00:00 to 12:00:00 with this function, and returns a result to the client.

In step 411, when the query data type is the cumulative quantity, components corresponding to respective time periods are calculated based on adjacent cumulative quantities in the data storage table.

When querying a cumulative quantity, it is usually necessary to perform data decomposition first, that is, calculate components of time periods, so as to perform data statistics or other joint calculations, such as calculating the electricity bill by combining the electric meter reading with the electricity price. The database server subtracts a cumulative quantity corresponding to a previous moment from a cumulative quantity corresponding to each moment to obtain a component corresponding to each time period.

In some embodiments, the query data type is the cumulative quantity, the query time condition is a sixth moment, and the target data is determined based on the sixth moment. When a user needs to query a cumulative quantity at a certain time, the database server queries and directly returns the cumulative quantity at that moment.

In step 412, target components belonging to a target time period indicated by the query time condition are queried.

In some embodiments, after decomposing the components corresponding to the respective time periods, the database server determines a target component that a user needs to query based on a target time period.

In some embodiments, if a user needs to query an electric meter reading acquired by the IoT device and needs the electricity consumption and electricity bill for each day in September, and the database server stores an electric meter reading for each day from September 1 to September 30, namely each day's cumulative electricity consumption, the database server first starts with data of the second day, and subtracts a cumulative quantity of a previous day from a cumulative quantity per day to obtain a daily electricity consumption in September.

In step 413, target data is determined based on the target components.

Upon acquiring components of the cumulative quantity in respective time periods, the database server performs data statistics or calculation on target components to determine target data. In some embodiments, if a user needs to query fees of a certain cumulative quantity in respective time periods within a period of time, it is necessary to calculate in combination with components of the cumulative quantity in the respective time periods and the cost.

In some embodiments, if a user needs to query an electric meter reading acquired by the IoT device and the electricity consumption and electricity bill for each day in September, the database server subtracts a cumulative quantity of a previous day from a cumulative quantity per day starting from data of the second day to obtain a daily electricity consumption in September, and then calculates a daily electricity bill in combination with the electricity price in September.

It should be noted that no strict order is defined between step 408 and steps 409 to 410, and steps 411 to 413. That is, step 408, steps 409 to 410, and steps 411 to 413 may be performed synchronously, which is not limited in this embodiment.

In the embodiments of the present disclosure, data types are categorized into state quantities, analog quantities, and cumulative quantities based on their change characteristics over time, and a different data compression method is adopted for each data type, which maximizes the compression rate and saves system resources. Different types of data are stored in different data storage tables. On this basis, a variety of query functions are provided for the database server. Users can query data and its statistics or calculation results according to actual needs, which improves the query capability of the database server.

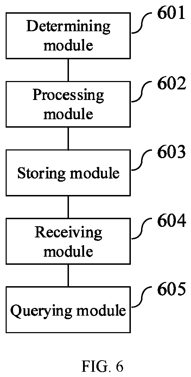

FIG. 6 is a structural block diagram of an apparatus for storing and querying time series data according to an exemplary embodiment of the present disclosure. The apparatus may be disposed in the database server described in the above embodiment. As shown in FIG. 6, the apparatus includes:
a determining module 601, configured to, upon receiving data to be stored from an IoT device, determine a data type of the data to be stored, wherein the data to be stored is time series data, and the data type is intended to indicate a change in the time series data over time;
a processing module 602, configured to obtain compressed data by compressing the data to be stored by a data compression method corresponding to the data type, wherein different data types correspond to different data compression methods;
a storing module 603, configured to store the compressed data to a data storage table corresponding to the data type, wherein different data types correspond to different data storage tables;
a receiving module 604, configured to receive a query request, wherein the query request includes a query data type and a query time condition; and
a querying module 605, configured to query target data that meets the query time condition from a data storage table corresponding to the query data type.

Optionally, the data to be stored is a state quantity; the state quantity is a physical quantity that is discontinuous over time and has a value belonging to a preset enumerated data set; and the processing module 602 includes:
a first acquiring unit, configured to read values of n pieces of data to be stored that are continuously received, where n is an integer greater than or equal to 2; and
a first compressing unit, configured to obtain the compressed data by compressing the data to be stored based on changes in the values of the n pieces of data to be stored.

Optionally, the compressing unit is further configured to:
for an (i+1)^{th} piece of data to be stored among the n pieces of data to be stored, retain the (i+1)^{th} piece of data to be stored if a value of the (i+1)^{th} piece of data to be stored is different from that of an i^{th} piece of data to be stored, wherein i is an integer greater than or equal to 1; and
delete the (i+1)^{th} piece of data to be stored if the value of the (i+1)^{th} piece of data to be stored is the same as that of the i^{th} piece of data to be stored.

Optionally, the query data type is the state quantity; and the querying module 605 includes:
a first determining unit, configured to determine data corresponding to a second moment in the data storage table to be the target data if the query time condition is a first moment and the data storage table corresponding to the state quantity does not store data corresponding to the first moment, wherein the second moment is before the first moment and is closest to the first moment.

Optionally, the data to be stored is an analog quantity; the analog quantity is a physical quantity that is continuous over time and has a value within a preset value range; and the processing module 602 further includes:
a second compressing unit, configured to obtain the compressed data by sampling and compressing the data to be stored based on an acquisition frequency of the data to be stored and a target sampling frequency, wherein the acquisition frequency is higher than the target sampling frequency.

Optionally, the query data type is the analog quantity; and the querying module 605 further includes:
a second acquiring unit configured to acquire data corresponding to at least one fourth moment and at least one fifth moment in the data storage table if the query time condition is a third moment and the data storage table corresponding to the analog quantity does not store data corresponding to the third moment, wherein the fourth moment is before the third moment and closest to the third moment, and the fifth moment is after the third moment and closest to the third moment; and
a first calculating unit, configured to calculate target data corresponding to the third moment by an interpolation algorithm based on the data corresponding to the fourth moment and the fifth moment.

Optionally, the data to be stored is a cumulative quantity; the cumulative quantity is a physical quantity whose value increases progressively over time; and the data to be stored is compressed by a preset lossless compression algorithm of a time series database.

The query data type is the cumulative quantity; and the querying module 605 further includes:
a second calculating unit, configured to calculate components corresponding to respective time periods based on adjacent cumulative quantities in the data storage table;
a querying unit, configured to query target components belonging to a target time period indicated by the query time condition; and
a second determining unit, configured to determine the target data based on the target components.

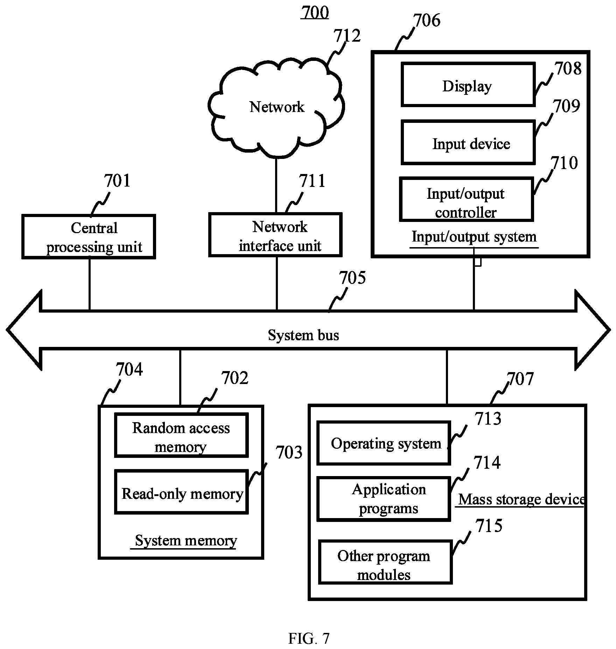

FIG. 7 shows a schematic structural diagram of a server according to an exemplary embodiment of the present disclosure. Specifically, the server 700 includes a central processing unit (CPU) 701, a system memory 704 including a random access memory (RAM) 702 and a read-only memory (ROM) 703, and a system bus 705 connecting the system memory 704 and the central processing unit 701. The server 700 also includes a basic input/output (I/O) system 706 that helps transfer information between various devices in the server, and a mass storage device 707 for storing an operating system 713, application programs 714, and other program modules 715.

The basic input/output system 706 includes a display 708 for displaying information and an input device 709 such as a mouse and a keyboard for a user to input information. The display 708 and the input device 709 are both connected to the central processing unit 701 by an input and output controller 710 connected to the system bus 705. The basic input/output system 706 may further include the input and output controller 710 for receiving and processing inputs from a plurality of other devices such as a keyboard, a mouse, or an electronic stylus. Similarly, the input and output controller 710 also provides outputs to a display screen, a printer, or other types of output devices.

The mass storage device 707 is connected to the central processing unit 701 by a mass storage controller (not shown) connected to the system bus 705. The mass storage device 707 and its associated server-readable storage medium provide nonvolatile storage for the server 700. That is, the mass storage device 707 may include a server-readable storage medium (not shown) such as a hard disk or a compact disc read-only memory (CD-ROM) drive.

Without loss of generality, the server-readable storage medium may include a server storage medium and a communication medium. The server storage medium includes volatile and nonvolatile, removable and non-removable medium implemented in any method or technology for storing information such as server-readable storage instructions, data structures, program modules, or other data. The server storage medium includes a RAM, a ROM, an erasable programmable read-only memory (EPROM), an electrically erasable programmable read-only memory (EEPROM), a flash memory, or other solid state storage devices, a CD-ROM, a digital versatile disk (DVD) or other optical storage devices, a tape cassette, a magnetic tape, a disk storage or other magnetic storage devices. Those skilled in the art may know that the server storage medium is not limited to the foregoing. The aforementioned system memory 704 and mass storage device 707 may be collectively referred to as memory.

The memory stores one or more programs configured to be run by one or more central processing units 701 and including instructions for performing the above-mentioned method for storing and querying time series data. The central processing unit 701 run the one or more programs to perform the method for storing and querying time series data according to the above method embodiments.

According to various embodiments of the present disclosure, the server 700 may also be connected to a remote server over a network such as the Internet to run. That is, the server 700 may be connected to a network 712 by a network interface unit 711 connected to the system bus 705. In other words, the network interface unit 711 may also be used to connect to other types of networks or remote server systems (not shown).

The memory further includes one or more programs. The one or more programs include instructions to perform the steps performed by the database server in the method provided in the embodiments of the present disclosure.

An embodiment of the present disclosure further provides a computer-readable storage medium storing at least one computer program including at least one instruction. The at least one instruction, when loaded and executed by a processor, causes the processor to perform the method for storing and querying time series data described in the above embodiments.

An embodiment of the present disclosure further provides a computer program product storing at least one instruction therein. The at least one instruction, when loaded and executed by a processor, causes the processor to perform the method for storing and querying time series data described in the above embodiments.

Those skilled in the art may be aware that, in one or more of the foregoing examples, the functions described in the embodiments of the present disclosure may be implemented by hardware, software, firmware, or any combination thereof. When implemented by software, these functions may be stored in a computer-readable storage medium or transmitted as one or more instructions or codes on the computer-readable storage medium. The computer-readable storage medium includes a computer storage medium and a communication medium. The communication medium includes any medium that facilitates the transfer of a computer program from one place to another. The storage medium may be any available medium that may be accessed by a general-purpose or special-purpose computer.

The above are merely exemplary embodiments of the present disclosure, but are not intended to limit the present disclosure.

## Claims

1. A computer-implemented method (200) for storing and querying time series data, comprising:
upon receiving data to be stored from an Internet of things, IoT, device, determining (201) a data type of the data to be stored, wherein the data to be stored is time series data, and the data type is intended to indicate a change in the time series data over time;
obtaining (202) compressed data by compressing the data to be stored by a data compression method corresponding to the data type, wherein different data types correspond to different data compression methods;
storing (203) the compressed data to a data storage table corresponding to the data type, wherein different data types correspond to different data storage tables;
receiving (204) a query request, wherein the query request comprises a query data type and a query time condition; and
querying (205) target data that meets the query time condition from a data storage table corresponding to the query data type;
wherein the data to be stored comprises a state quantity, wherein the state quantity is a physical quantity that is discontinuous over time and has a value belonging to a preset enumerated data set, and obtaining the compressed data by compressing the data to be stored by the data compression method corresponding to the data type comprises:
reading values of n pieces of state quantity that are continuously received, wherein n is an integer greater than or equal to 2; and
obtaining the compressed data by compressing the n pieces of state quantity based on changes in the values of the n pieces of state quantity.

2. The computer-implemented method according to claim 1, wherein obtaining the compressed data by compressing the stored pieces of state quantity based on the changes in the values of the n pieces of state quantity comprises:
for an (i+1)^{th} piece of state quantity among the n pieces of state quantity, retaining the (i+1)^{th} piece of state quantity if a value of the (i+1)^{th} piece of state quantity is different from that of an i^{th} piece of state quantity , wherein i is an integer greater than or equal to 1; and
deleting the (i+1)^{th} piece of state quantity if the value of the (i+1)^{th} piece of state quantity is the same as that of the i^{th} piece of state quantity.

3. The computer-implemented method according to claim 1, wherein the query data type comprises a state quantity, and querying the target data that meets the query time condition from the data storage table corresponding to the query data type comprises:
determining data corresponding to a second moment in the data storage table corresponding to the state quantity as the target data if the query time condition is a first moment and the data storage table corresponding to the state quantity does not store data corresponding to the first moment, wherein the second moment is before the first moment and is closest to the first moment.

4. The computer- implemented method according to claim 1, wherein the data to be stored further comprises an analog quantity, wherein the analog quantity is a physical quantity that is continuous over time and has a value within a preset value range, and obtaining the compressed data by compressing the data to be stored by the data compression method corresponding to the data type further comprises:
obtaining the compressed data by sampling and compressing the analog quantity based on an acquisition frequency of the analog quantity and a target sampling frequency, wherein the acquisition frequency is higher than the target sampling frequency.

5. The computer-implemented method according to claim 4, wherein the query data type further comprises an analog quantity, and querying the target data that meets the query time condition from the data storage table corresponding to the query data type comprises:
acquiring data corresponding to at least one fourth moment and at least one fifth moment in the data storage table corresponding to the analog quantity if the query time condition is a third moment and the data storage table corresponding to the analog quantity does not store data corresponding to the third moment, wherein the fourth moment is before the third moment and closest to the third moment, and the fifth moment is after the third moment and closest to the third moment; and
calculating the target data corresponding to the third moment by an interpolation algorithm based on the data corresponding to the fourth moment and the fifth moment.

6. The computer-implemented method according to claim 1, wherein the data to be stored further comprises a cumulative quantity, wherein the cumulative quantity is a physical quantity whose value increases progressively over time, and the data to be stored is compressed by a preset lossless compression algorithm in a time series database; and
the query data type is the cumulative quantity, and querying the target data that meets the query time condition from the data storage table corresponding to the query data type further comprises:
calculating components corresponding to respective time periods based on adjacent cumulative quantities in a data storage table corresponding to the cumulative quantity;
querying target components belonging to a target time period indicated by the query time condition; and
determining the target data based on the target components.

7. An apparatus for storing and querying time series data, comprising:
a determining module (601), configured to, upon receiving data to be stored from an Internet of things (IoT) device, determine a data type of the data to be stored, wherein the data to be stored is time series data, and the data type is intended to indicate a change in the time series data over time;
a processing module (602), configured to obtain compressed data by compressing the data to be stored by a data compression method corresponding to the data type, wherein different data types correspond to different data compression methods;
a storing module (603), configured to store the compressed data to a data storage table corresponding to the data type, wherein different data types correspond to different data storage tables;
a receiving module (604), configured to receive a query request, wherein the query request comprises a query data type and a query time condition; and
a querying module (605), configured to query target data that meets the query time condition from a data storage table corresponding to the query data type;
wherein the data to be stored comprises a state quantity, wherein the state quantity is a physical quantity that is discontinuous over time and has a value belonging to a preset enumerated data set, and obtaining the compressed data by compressing the data to be stored by the data compression method corresponding to the data type comprises:
reading values of n pieces of state quantity that are continuously received, wherein n is an integer greater than or equal to 2; and
obtaining the compressed data by compressing the n pieces of state quantity based on changes in the values of the n pieces of state quantity.

8. A server (700), comprising: a processor (701); and a memory (704) storing at least one instruction, at least one program, a code set, or an instruction set, wherein the at least one instruction, the at least one program, the code set, or the instruction set, when loaded and executed by the processor, causes the processor to perform the method for storing and querying time series data as defined in any one of claims 1 to 6.

9. A computer-readable storage medium storing at least one instruction, at least one program, a code set, or an instruction set, wherein the at least one instruction, the at least one program, the code set, or the instruction set, when loaded and executed by a processor, causes the processor to perform the method for storing and querying time series data as defined in any one of claims 1 to 6.

## Patentansprüche

1. Computergestütztes Verfahren (200) zum Speichern und Abfragen von Zeitreihendaten, Folgendes umfassend:
beim Empfang von zu speichernden Daten von einem IoT-Gerät (Internet of Things/Internet der Dinge), Ermitteln (201) eines Datentyps der zu speichernden Daten, wobei es sich bei den zu speichernden Daten um Zeitreihendaten handelt und der Datentyp eine Veränderung der Zeitreihendaten im Zeitverlauf anzeigen soll;
Erhalten (202) von komprimierten Daten durch Komprimieren der zu speichernden Daten mit einem dem Datentyp entsprechenden Datenkomprimierungsverfahren, wobei verschiedene Datentypen verschiedenen Datenkomprimierungsverfahren entsprechen;
Speichern (203) der komprimierten Daten in einer dem Datentyp entsprechenden Datenspeichertabelle, wobei verschiedene Datentypen verschiedenen Datenspeichertabellen entsprechen;
Empfangen (204) einer Abfrageanforderung, wobei die Abfrageanforderung einen Abfragedatentyp und eine Abfragezeitbedingung umfasst; und
Abfragen (205) von Zieldaten, die die Abfragezeitbedingung erfüllen, von einer dem Abfragedatentyp entsprechenden Datenspeichertabelle;
wobei die zu speichernden Daten eine Zustandsgröße umfassen, wobei es sich bei der Zustandsgröße um eine physikalische Größe handelt, die im Zeitverlauf diskontinuierlich ist und einen zu einem voreingestellten aufgezählten Datensatz gehörenden Wert hat, und das Erhalten der komprimierten Daten durch Komprimieren der zu speichernden Daten mit einem dem Datentyp entsprechenden Datenkomprimierungsverfahren Folgendes umfasst:
Lesen der Werte von n Teilen der Zustandsgröße, die kontinuierlich empfangen werden, wobei es sich bei n um eine Ganzzahl größer oder gleich 2 handelt; und
Erhalten der komprimierten Daten durch Komprimieren der n Teile der Zustandsgröße basierend auf Veränderungen der Werte der n Teile der Zustandsgröße.

2. Computergestütztes Verfahren nach Anspruch 1, wobei das Erhalten der komprimierten Daten durch Komprimieren der gespeicherten Teile der Zustandsgröße basierend auf den Veränderungen der Werte der n Teile der Zustandsgröße Folgendes umfasst:
für einen (i+1)-ten Teil der Zustandsgröße von den n Teilen der Zustandsgröße, Beibehalten des (i+1)-ten Teils der Zustandsgröße, wenn ein Wert des (i+1)-ten Teils der Zustandsgröße von dem Wert eines i-ten Teils der Zustandsgröße abweicht, wobei i eine Ganzzahl größer oder gleich 1 ist; und
Löschen des (i+1)-ten Teils der Zustandsgröße, wenn der Wert des (i+1)-ten Teils der Zustandsgröße gleich dem Wert des i-ten Teils der Zustandsgröße ist.

3. Computergestütztes Verfahren nach Anspruch 1, wobei der Abfragedatentyp eine Zustandsgröße umfasst und das Abfragen der Zieldaten, die die Abfragezeitbedingung erfüllen, von der dem Abfragedatentyp entsprechenden Datenspeichertabelle Folgendes umfasst:
Ermitteln von Daten, die einem zweiten Zeitpunkt in der der Zustandsgröße entsprechenden Datenspeichertabelle entsprechen, als Zieldaten, wenn die Abfragezeitbedingung ein erster Zeitpunkt ist und in der der Zustandsgröße entsprechenden Datenspeichertabelle keine dem ersten Zeitpunkt entsprechenden Daten gespeichert sind, wobei der zweite Zeitpunkt vor dem ersten Zeitpunkt ist und dem ersten Zeitpunkt am nächsten ist.

4. Computergestütztes Verfahren nach Anspruch 1, wobei die zu speichernden Daten ferner eine analoge Größe umfassen, wobei es sich bei der analogen Größe um eine physikalische Größe handelt, die im Zeitverlauf kontinuierlich ist und einen Wert innerhalb eines voreingestellten Wertebereichs hat, und das Erhalten der komprimierten Daten durch Komprimieren der zu speichernden Daten mit dem dem Datentyp entsprechenden Datenkomprimierungsverfahren ferner Folgendes umfasst:
Erhalten der komprimierten Daten durch Abtasten und Komprimieren der analogen Größe basierend auf einer Erfassungsfrequenz der analogen Größe und einer Zielabtastfrequenz, wobei die Erfassungsfrequenz höher ist als die Zielabtastfrequenz.

5. Computergestütztes Verfahren nach Anspruch 4, wobei der Abfragedatentyp ferner eine analoge Größe umfasst und das Abfragen der Zieldaten, die die Abfragezeitbedingung erfüllen, von der dem Abfragedatentyp entsprechenden Datenspeichertabelle Folgendes umfasst:
Erfassen von Daten, die mindestens einem vierten Zeitpunkt und mindestens einem fünften Zeitpunkt in der der analogen Größe entsprechenden Datenspeichertabelle entsprechen, wenn die Abfragezeitbedingung ein dritter Zeitpunkt ist und in der der analogen Größe entsprechenden Datenspeichertabelle keine dem dritten Zeitpunkt entsprechenden Daten gespeichert sind, wobei der vierte Zeitpunkt vor dem dritten Zeitpunkt ist und dem dritten Zeitpunkt am nächsten ist und der fünfte Zeitpunkt nach dem dritten Zeitpunkt und dem dritten Zeitpunkt am nächsten ist; und
Berechnen der dem dritten Zeitpunkt entsprechenden Zieldaten durch einen Interpolationsalgorithmus basierend auf den dem vierten Zeitpunkt und dem fünften Zeitpunkt entsprechenden Daten.

6. Computergestütztes Verfahren nach Anspruch 1, wobei die zu speichernden Daten ferner eine kumulative Größe umfassen, wobei es sich bei der kumulativen Größe um eine physikalische Größe handelt, deren Wert im Zeitverlauf progressiv steigt, und die zu speichernden Daten durch einen voreingestellten verlustfreien Komprimierungsalgorithmus in einer Zeitreihendatenbank komprimiert werden; und
der Abfragedatentyp die kumulative Größe ist und das Abfragen der Zieldaten, die die Abfragezeitbedingung erfüllen, von der dem Abfragedatentyp entsprechenden Datenspeichertabelle ferner Folgendes umfasst:
Berechnen von jeweiligen Zeiträumen entsprechenden Komponenten basierend auf angrenzenden kumulativen Größen in einer der kumulativen Größe entsprechenden Datenspeichertabelle;
Abfragen von Zielkomponenten, die zu einem durch die Abfragezeitbedingung angegebenen Zielzeitraum gehören; und
Ermitteln der Zieldaten basierend auf den Zielkomponenten.

7. Gerät zum Speichern und Abfragen von Zeitreihendaten, Folgendes umfassend:
ein Ermittlungsmodul (601), das dazu konfiguriert ist, beim Empfang von zu speichernden Daten von einem IoT-Gerät (Internet of Things/Internet der Dinge) einen Datentyp der zu speichernden Daten zu ermitteln, wobei es sich bei den zu speichernden Daten um Zeitreihendaten handelt und der Datentyp eine Veränderung der Zeitreihendaten im Zeitverlauf anzeigen soll;
ein Verarbeitungsmodul (602), das dazu konfiguriert ist, komprimierte Daten durch Komprimieren der zu speichernden Daten mit einem dem Datentyp entsprechenden Datenkomprimierungsverfahren zu erhalten, wobei verschiedene Datentypen verschiedenen Datenkomprimierungsverfahren entsprechen;
ein Speichermodul (603), das dazu konfiguriert ist, die komprimierten Daten in einer dem Datentyp entsprechenden Datenspeichertabelle zu speichern, wobei verschiedene Datentypen verschiedenen Datenspeichertabellen entsprechen;
ein Empfangsmodul (604), das dazu konfiguriert ist eine Abfrageanforderung zu empfangen, wobei die Abfrageanforderung einen Abfragedatentyp und eine Abfragezeitbedingung umfasst; und
ein Abfragemodul (605), das dazu konfiguriert ist, Zieldaten, die die Abfragezeitbedingung erfüllen, von einer dem Abfragedatentyp entsprechenden Datenspeichertabelle abzufragen;
wobei die zu speichernden Daten eine Zustandsgröße umfassen, wobei es sich bei der Zustandsgröße um eine physikalische Größe handelt, die im Zeitverlauf diskontinuierlich ist und einen zu einem voreingestellten aufgezählten Datensatz gehörenden Wert hat, und das Erhalten der komprimierten Daten durch Komprimieren der zu speichernden Daten mit einem dem Datentyp entsprechenden Datenkomprimierungsverfahren Folgendes umfasst:
Lesen der Werte von n Teilen der Zustandsgröße, die kontinuierlich empfangen werden, wobei es sich bei n um eine Ganzzahl größer oder gleich 2 handelt; und
Erhalten der komprimierten Daten durch Komprimieren der n Teile der Zustandsgröße basierend auf Veränderungen der Werte der n Teile der Zustandsgröße.

8. Server (700), Folgendes umfassend: einen Prozessor (701); und einen Speicher (704), in dem mindestens eine Anweisung, mindestens ein Programm, ein Codesatz oder ein Anweisungssatz gespeichert sind, wobei die mindestens eine Anweisung, das mindestens eine Programm, der Codesatz oder der Anweisungssatz, wenn sie geladen und vom Prozessor ausgeführt werden, den Prozessor dazu veranlassen, das Verfahren zum Speichern und Abfragen von Zeitreihendaten nach einem der Ansprüche 1 bis 6 auszuführen.

9. Computerlesbares Speichermedium, auf dem mindestens eine Anweisung, mindestens ein Programm, ein Codesatz oder ein Anweisungssatz gespeichert sind, wobei die mindestens eine Anweisung, das mindestens eine Programm, der Codesatz oder der Anweisungssatz, wenn sie geladen und von einem Prozessor ausgeführt werden, den Prozessor dazu veranlassen, das Verfahren zum Speichern und Abfragen von Zeitreihendaten nach einem der Ansprüche 1 bis 6 auszuführen.

## Revendications

1. Procédé mis en oeuvre par ordinateur (200) pour stocker et interroger des données de série chronologiques, comprenant :
lors de la réception de données devant être stockées à partir d'un dispositif Internet des objets, loT, la détermination (201) d'un type de données des données devant être stockées, dans lequel les données devant être stockées sont des données de série chronologiques, et le type de données est destiné à indiquer un changement dans les données de série chronologique au fil du temps ;
l'obtention (202) de données compressées en compressant les données devant être stockées au moyen d'un procédé de compression de données correspondant au type de données, dans lequel différents types de données correspondent à différents procédés de compression de données ;
le stockage (203) des données compressées dans une table de stockage de données correspondant au type de données, dans lequel différents types de données correspondent à différentes tables de stockage de données ;
la réception (204) d'une demande d'interrogation, dans lequel la demande d'interrogation comprend un type de données d'interrogation et une condition de temps d'interrogation ; et
l'interrogation (205) de données cibles qui satisfont à la condition de temps d'interrogation à partir d'une table de stockage de données correspondant au type de données d'interrogation ;
dans lequel les données devant être stockées comprennent une quantité d'état, dans lequel la quantité d'état est une quantité physique qui est discontinue au fil du temps et a une valeur appartenant à un ensemble de données énumérées prédéfini, et l'obtention des données compressées en compressant les données devant être stockées au moyen du procédé de compression de données correspondant au type de données comprend :
la lecture de valeurs de n éléments de quantité d'état qui sont reçus en continu, dans lequel n est un nombre entier supérieur ou égal à 2 ; et
l'obtention des données compressées en compressant les n éléments de quantité d'état sur la base de changements dans les valeurs des n éléments de quantité d'état.

2. Procédé mis en oeuvre par ordinateur selon la revendication 1, dans lequel l'obtention des données compressées en compressant les éléments de quantité d'état stockés sur la base des changements dans les valeurs des n éléments de quantité d'état comprend :
pour un (i+1)^{ème} élément de quantité d'état parmi les n éléments de quantité d'état, la conservation du (i+1)^{ème} élément de quantité d'état si une valeur du (i+1)^{ème} élément de quantité d'état est différente de celle d'un i^{ème} élément de quantité d'état, dans lequel i est un entier supérieur ou égal à 1 ; et
la suppression du (i+1)^{ème} élément de quantité d'état si la valeur du (i+1)^{ème} élément de quantité d'état est la même que celle du i^{ème} élément de quantité d'état.

3. Procédé mis en oeuvre par ordinateur selon la revendication 1, dans lequel le type de données d'interrogation comprend une quantité d'état, et l'interrogation des données cibles qui satisfont à la condition de temps d'interrogation à partir de la table de stockage de données correspondant au type de données d'interrogation comprend :
la détermination de données correspondant à un deuxième moment dans la table de stockage de données correspondant à la quantité d'état en tant que données cibles si la condition de temps d'interrogation est un premier moment et que la table de stockage de données correspondant à la quantité d'état ne stocke pas de données correspondant au premier moment, dans lequel le deuxième moment est avant le premier moment et est le plus proche du premier moment.

4. Procédé mis en oeuvre par ordinateur selon la revendication 1, dans lequel les données devant être stockées comprennent en outre une quantité analogique, dans lequel la quantité analogique est une quantité physique qui est continue au fil du temps et a une valeur dans une plage de valeurs prédéfinie, et l'obtention des données compressées en compressant les données devant être stockées au moyen du procédé de compression de données correspondant au type de données comprend en outre :
l'obtention des données compressées par échantillonnage et compression de la quantité analogique sur la base d'une fréquence d'acquisition de la quantité analogique et d'une fréquence d'échantillonnage cible, dans lequel la fréquence d'acquisition est supérieure à la fréquence d'échantillonnage cible.

5. Procédé mis en oeuvre par ordinateur selon la revendication 4, dans lequel le type de données d'interrogation comprend en outre une quantité analogique, et l'interrogation des données cibles qui satisfont à la condition de temps d'interrogation à partir de la table de stockage de données correspondant au type de données d'interrogation comprend :
l'acquisition de données correspondant à au moins un quatrième moment et à au moins un cinquième moment dans la table de stockage de données correspondant à la quantité analogique si la condition de temps d'interrogation est un troisième moment et que la table de stockage de données correspondant à la quantité analogique ne stocke pas de données correspondant au troisième moment, dans lequel le quatrième moment est avant le troisième moment et le plus proche du troisième moment, et le cinquième moment est après le troisième moment et le plus proche du troisième moment ; et
le calcul des données cibles correspondant au troisième moment au moyen d'un algorithme d'interpolation sur la base des données correspondant au quatrième moment et au cinquième moment.

6. Procédé mis en oeuvre par ordinateur selon la revendication 1, dans lequel les données devant être stockées comprennent en outre une quantité cumulée, dans lequel la quantité cumulée est une quantité physique dont la valeur augmente progressivement au fil du temps, et les données devant être stockées sont compressées au moyen d'un algorithme de compression sans perte prédéfini dans une base de données de série chronologiques ; et
le type de données d'interrogation est la quantité cumulée, et l'interrogation des données cibles qui satisfont à la condition de temps d'interrogation à partir de la table de stockage de données correspondant au type de données d'interrogation comprend :
le calcul de composants correspondant à des périodes de temps respectives sur la base de quantités cumulées adjacentes dans une table de stockage de données correspondant à la quantité cumulée ;
l'interrogation des composants cibles appartenant à une période de temps cible indiquée par la condition de temps d'interrogation ; et
la détermination des données cibles sur la base des composants cibles.

7. Appareil pour stocker et interroger des données de série chronologiques, comprenant :
un module de détermination (601), configuré pour déterminer, lors de la réception de données devant être stockées à partir d'un dispositif Internet des objets (loT), un type de données des données devant être stockées, dans lequel les données devant être stockées sont des données de série chronologiques, et le type de données est destiné à indiquer un changement dans les données de série chronologique au fil du temps ;
un module de traitement (602), configuré pour obtenir des données compressées en compressant les données devant être stockées au moyen d'un procédé de compression de données correspondant au type de données, dans lequel différents types de données correspondent à différents procédés de compression de données ;
un module de stockage (603), configuré pour stocker les données compressées dans une table de stockage de données correspondant au type de données, dans lequel différents types de données correspondent à différentes tables de stockage de données ;
un module de réception (604), configuré pour recevoir une demande d'interrogation, dans lequel la demande d'interrogation comprend un type de données d'interrogation et une condition de temps d'interrogation ; et
un module d'interrogation (605), configuré pour interroger des données cibles qui satisfont à la condition de temps d'interrogation à partir d'une table de stockage de données correspondant au type de données d'interrogation ;
dans lequel les données devant être stockées comprennent une quantité d'état, dans lequel la quantité d'état est une quantité physique qui est discontinue au fil du temps et a une valeur appartenant à un ensemble de données énumérées prédéfini, et l'obtention des données compressées en compressant les données devant être stockées au moyen du procédé de compression de données correspondant au type de données comprend :
la lecture de valeurs de n éléments de quantité d'état qui sont reçus en continu, dans lequel n est un nombre entier supérieur ou égal à 2 ; et
l'obtention des données compressées en compressant les n éléments de quantité d'état sur la base de changements dans les valeurs des n éléments de quantité d'état.

8. Serveur (700), comprenant : un processeur (701) ; et une mémoire (704) stockant au moins une instruction, au moins un programme, un jeu de codes ou un jeu d'instructions, dans lequel l'au moins une instruction, l'au moins un programme, le jeu de codes ou le jeu d'instructions, lorsqu'ils sont chargés et exécutés par le processeur, amènent le processeur à réaliser le procédé de stockage et d'interrogation de données de série chronologiques tel que défini dans l'une quelconque des revendications 1 à 6.

9. Support de stockage lisible par ordinateur stockant au moins une instruction, au moins un programme, un jeu de codes ou un jeu d'instructions, dans lequel l'au moins une instruction, l'au moins un programme, le jeu de codes ou le jeu d'instructions, lorsqu'ils sont chargés et exécutés par un processeur, amènent le processeur à réaliser le procédé de stockage et d'interrogation de données de série chronologiques tel que défini dans l'une quelconque des revendications 1 à 6.
